Europäisches Patentamt

(19) European Patent Office    (11) Publication number: **0 090 521**
Office européen des brevets                               **B1**

(12) **EUROPEAN PATENT SPECIFICATION**

(45) Date of publication of patent specification: **01.06.88**    (51) Int. Cl.⁴: **H 01 L 21/208**

(21) Application number: **83301264.4**

(22) Date of filing: **08.03.83**

(54) **A method of performing solution growth of a group III-V compound semiconductor crystal layer under control of the conductivity type thereof.**

(30) Priority: **09.03.82 JP 37526/82**

(43) Date of publication of application:
**05.10.83 Bulletin 83/40**

(45) Publication of the grant of the patent:
**01.06.88 Bulletin 88/22**

(84) Designated Contracting States:
**DE FR GB**

(56) References cited:
**US-A-3 600 240**
**US-A-4 142 924**

**JAPANESE JOURNAL OF APPLIED PHYSICS,
vol. 8, no. 3, March 1969, pages 348-357, Tokyo,
JP; T. MORIIZUMI et al.: "Si- and Ge-doped
GaAs p-n junctions"**

**JOURNAL OF THE ELECTROCHEMICAL
SOCIETY, vol. 124, no. 23, March 1977, pages
441-447, Princeton, US; M. OTSUBO et al.:
"Liquid phase epitaxial growth of semi-
insulating GaAs crystals"**

(73) Proprietor: **ZAIDAN HOJIN HANDOTAI KENKYU
SHINKOKAI
Kawauchi 2
Sendai-shi Miyagi 980 (JP)**

(72) Inventor: **Nishizawa, Jun-Ichi
No. 6-16, Komegafukuro 1-chome
Sendai-shi Miyagi-ken (JP)**

(74) Representative: **Laredo, Jack Joseph et al
Elkington and Fife High Holborn House 52/54
High Holborn
London, WC1V 6SH (GB)**

(56) References cited:
**TECHNISCH-WISSENSCHAFTLICHE
ABHANDLUNGEN DER OSRAM-
GESELLSCHAFT, no. 11, 1973, pages 235-239,
Berlin, DE; F. PORTELE et al.:
"Schmelzepitaktische Herstellung Si-dotierter
GaAs-Schichten für Festkörperlampen"**

Courier Press, Leamington Spa, England.

## Description

### Background of the Invention
#### a) Field of the invention:

The present invention relates generally to a method of performing a growth of a Group III—V compound semiconductor crystal layer from solution, and more particularly it pertains to a method of doing so while controlling the conductivity type of this layer as desired. Still more particularly, the present invention concerns a method of solution growth of such compound semiconductor crystal layer as mentioned above which uses a melt, serving as the solution, in which a Group IV element is doped as an impurity atom source for determining the conductivity type of said layer and by relying on the temperature difference technique under a vapor pressure control of the Group V element which constitutes said compound.

#### b) Description of the prior art:

In case a semiconductor device is manufactured, on a substrate, by an epitaxial growth of a Group III—V compound semiconductor crystal as represented typically by GaAs, such manufacture mostly relies upon a solution growth method. However, the solution growth method which has been generally employed conventionally for the growth of a Group III—V compound semiconductor is the so-called Nelson method which has been developed by RCA Corporation of U.S.A. This Nelson method comprises the steps of dipping a substrate crystal in a melt which has been prepared by using an appropriate metal as a solvent and by dissolving a Group III—V compound semiconductor crystal and also atoms of a required impurity in said solvent; subjecting the resulting solution to a slow cooling step thereby causing recrystallization of the supersaturating Group III—V compound semiconductor on said substrate. In such case, the crystal growth is conducted through a cooling process. Accordingly, the growth temperature varies in the direction of the thickness of the layer which is grown. Thus, this known method has the drawbacks that the amount of the impurity serving as the dopant would change, and that, in case of a mixed crystal, the composition of the crystal would change also. The typical example thereof is represented by the relationship between the growth temperature and the conductivity type of GaAs doped with Si which is an amphoteric impurity which may produce an $n$ type and a $p$ type conductivity. In case an Si-doped GaAs is grown by relying on the conventional slow-cooling method of Nelson mentioned above, the crystal at the high temperature zone will exhibit an $n$ type conductivity, and as the growth temperature is lowered, the conductivity becomes lower, and when, via a high resistivity region, the temperature is lowered to a further extent, the conductivity type develops a conversion so that the crystal will now exhibit a $p$ type conductivity. There has been proposed a method of forming a $p$-$n$ junction in a single growth process by positively utilizing this phenomenon of conversion. However, the presence of such phenomenon also serves to demonstrate that the grown layer obtained by this slow-cooling method is not uniform in its body.

The reason why such conversion of conductivity type takes place has been said to be due to the fact that, at a high temperature, atoms of Si easily enter substitutionally into the lattice sites of Ga atoms to thereby provide an $n$ type, and that, at a low temperature, Si atoms easily enter substitutionally into the lattice sites of As atoms to thereby exhibit a $p$ type.

Accordingly, the abovesaid conventional $pn$ junction forming method utilizing the different patterns of substitution of such amphoteric impurity as Si into the lattice sites of a Group III—V compound semiconductor crystal, especially owing to the fact that the drawbacks of the so-called Nelson method of making a non-uniform crystal are positively made use of, will naturally develop poor crystal perfection, and the fluctuation of, for example, the cooling rate intensively affects the layer which is grown, and thus, even when atoms of an amphoteric impurity are introduced as a dopant into a melt, there actually has not been carried out such an ideal lattice substitution that the impurity atoms enter successfully into the desired lattice sites.

### Summary of the invention

It is, therefore, the object of the present invention to provide an improved solution growth method for Group III—V compound semiconductors, which eliminates those drawbacks of the prior art solution growth methods as mentioned above, and which enables one to obtain a grown crystal layer having uniform crystal characteristics in the direction of growth, and also which gives rise to a $p$-$n$ conversion phenomenon in an ideal fashion.

### Brief description of the drawings

Fig. 1 is a chart showing the result of experiment which indicates the relationship between the growth temperature and the amount of Si atoms contained in a melt, which are factors developing a conversion of the conductivity type from the $n$ type to the $p$ type when Si is doped in a GaAs crystal.

Fig. 2 is an explanatory sectional illustration showing an example of the arrangement of a solution growth apparatus which is employed in the present invention and which adopts both the vapor pressure control technique and the temperature difference technique.

Fig. 3 is a chart showing the relationship between the carrier concentration, the conductivity type and the density of Si atoms in a melt, in an Si-doped GaAs crystal according to the solution growth method of the present invention.

Fig. 4 is a chart showing the dependency of the carrier concentration upon the vapor-pressure of As in a Si-doped GaAs crystal in the solution growth method of the present invention, wherein Si/Ga = $3 \times 10^{-3}$ weight%.

Fig. 5 is a chart showing like dependency as mentioned above, wherein Si/Ga = $9.1 \times 10^{-3}$ weight%.

Fig. 6 is a chart showing like dependency as mentioned above, wherein Si/Ga = $1.1 \times 10^{-1}$ weight%.

Fig. 7 is a chart showing the relationship between the vapor pressure of As (which is obtained from an X-ray rocking curve), the lattice constant of the grown layer and the half width (wherein Si/Ga = $3 \times 10^{-3}$ weight%).

Fig. 8 is a chart showing similar relationships, wherein Si/Ga $9.1 \times 10^{-3}$ weight%.

Fig. 9 is a chart showing similar relationships, wherein Si/Ga = $1.1 \times 10^{-1}$ weight%.

Fig. 10 is a chart showing the relationship between the density of dopant Si/Ga and the As vapor pressure $P_{As\ min.}$ where the lattice constant as well as the rocking curve half width become minimum.

### Detailed description of the preferred embodiment

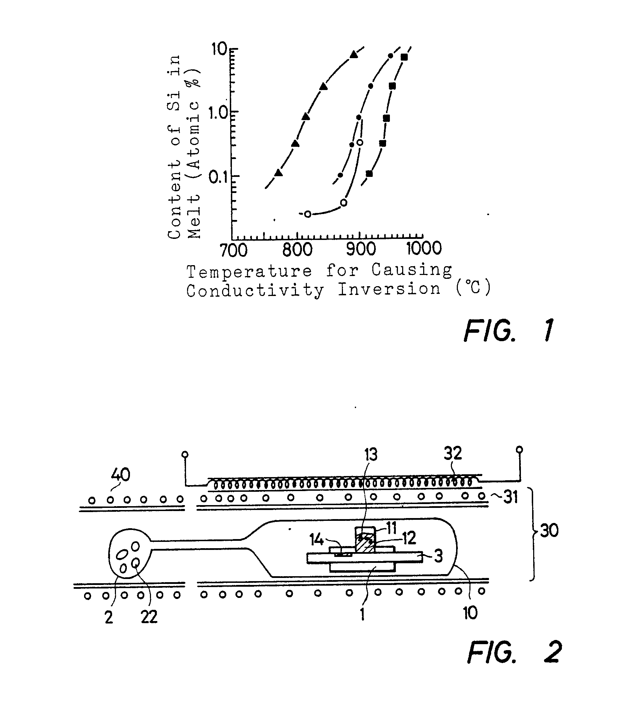

Fig. 1 is a chart showing the relationship between the growth temperature at which the *n*-type-to-*p* type conversion takes place and the Si content in the melt when a solution growth is conducted by relying on the conventional solution growth method.

In Fig. 1, mark ● indicates the relationship for the (100) face of the substrate crystal, and mark ■ for the (111)A face, and mark ▲ for the (111)B face. However, the conversion temperature at the (100) face in the present invention is shown also at mark O.

As will be noted from this result, the conversion temperature changes also with surface orientation. This chart also carries comparatively the result obtained by relying on the method of the present invention. As will be understood from a comparison of those solution growths for substrates having a same crystal surface orientation, there are noted significant differences in the conversion temperature owing to the different conditions of growth.

The solution growth apparatus employed in the present invention is one relying on the temperature difference technique under controlled vapor pressure which has been proposed earlier by the present inventor. Its schematic illustration is shown in Fig. 2.

Various arrangements of reactor system can be conceived such as the open tube type and the closed tube system. Therefore, it is needless to say that the arrangement of the solition growth apparatus is not limited to that shown here. In case of a solution growth of, for example, a GaAs crystal, the growth apparatus is provided with a growth boat 1 made of graphite, and a melt reservoir 11 containing therein a Ga melt 12 which, in turn, contains a required amount of Si, and on which is floated a GaAs crystal 13 which serves as the source crystal for the growth. A substrate crystal 14 is set in a recess formed in a slider 3. A chamber 2 which is formed within a quartz ampule 10 is provided in a separate temperature zone to apply, during the growth process, a constant vapor pressure of As which is a crystal-constituent element having a higher vapor pressure over the other constituent element Ga. This chamber 2 is connected, by a thin quartz tube, to the region where the growth boat is provided, for communication therewith. A metal As 22 is placed within this chamber 2. A growth furnace 30 is provided with a main heating means 31 for elevating the temperature of the whole apparatus, and also with a sub-heating means 32 intended for keeping only the upper portion of the growth boat at a high temperature. By these two heating means, the growth temperature and the temperature difference are set. Also, the vapor pressure of As which is introduced during the growth process is controlled of its vapor pressure by a vapor pressure control furnace 40 which is a unit separate from the growth furnace 30, and the vapor pressure for being applied is determined by the temperature of the As-containing chamber 2.

A growth proceeds by keeping constant the growth temperature, the temperature difference as well as the temperature of the As chamber, and by moving the slider 3 carried on the boat 1, and by establishing a contact between the melt and the substrate. Whereby, the Ga atoms and the As atoms in the melt move from the high temperature zone toward the low temperature zone, to recrystallize. After a growth duration for a predetermined length of time, the slider 3 is moved again to cause separation of the substrate off the melt, and the temperature of the growth furnace is lowered.

The shape of Si which is introduced into the Ga melt may be in the form of crystal, or there may be used a solution in which Si is dissolved in Ga.

According to the growth performed by relying on the abovesaid method, it is possible to obtain a very good grown layer because the deviation from stoichiometric composition can be minimized owing to the fact that the crystal growth is performed at a completely constant temperature and that the vapor pressure is controlled.

In case Si which is an impurity of the amphoteric type is added, in a crystal growth which is performed by using the solution growth apparatus mentioned above, there is obtained a result which is very effective for the conversion of the conductivity type without damaging the perfection of the crystal thus grown.

It is, therefore, the object of the present invention to provide a method for attaining the abovesaid result. The method of the present invention will hereunder be described in further detail with respect to the preferred embodiment thereof.

### Example 1

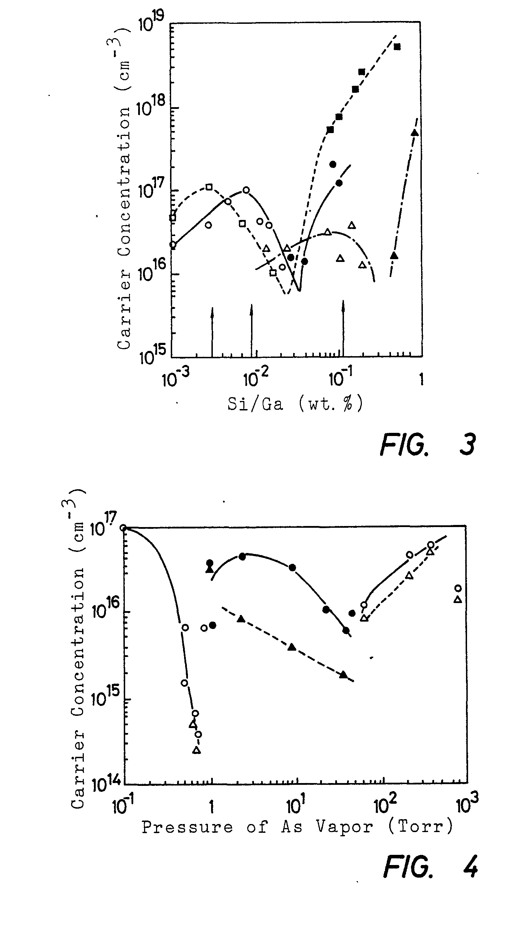

The dependency of the electrical characteristics of the grown GaAs crystal layer upon the Si density in a melt was examined. A crystal growth was performed under a constant growth temperature and a constant As pressure applied, and by using, as a parameter, the amount of Si which is introduced into the Ga melt. In order to examine the electrical characteristics of the grown layer, a Cr-doped GaAs crystal whose crystal orientation has a (100) face was used as the substrate. The carrier concentration and the conductivity type which are one of the electrical characteristics were measured in terms of Hall effect in van der Pauw method. The result of the examined carrier concentration and the conductivity type for the respective growth temperatures is shown in Fig. 3. As will be clear from this result, in each of the respective growth temperatures 820°C (notes: in the drawing, mark □ signifies the $n$ type, and mark ■ signifies the $p$ type), 875°C (in the drawing, mark ○ signifies the $n$ type, and mark ● signifies the $p$ type), and 900°C (in the drawing, mark △ signifies the $n$ type, and mark ▲ signifies the $p$ type), there invariably exists an Si density at which the conductivity type develops conversion. This Si density shifts toward the high density side as the growth temperature rises. From this result, it has become clear that, unlike in the conventional method, the conductivity (carrier concentration) and the conductivity type undergo a change even when the growth temperature does not change, i.e. even at a constant temperature. Such relationship is introduced into Fig. 1 which shows the conventional data, and considerably close values can be noted therein. However, the crystal perfection of the crystal obtained by the present invention is outstandingly superior to the conventional data, since the present invention is such that the amount of Si is varied under the condition that the growth temperature is held constant due to the adoption of the temperature difference technique and because the pressure of As vapor is controlled. This introduction of As pressure plays an important rôle for the object of the present invention to cause the conversion of the conductivity type. Therefore, description will next be made of the electrical characteristics of the crystal grown under a constant growth temperature and a constant amount of the Si added to the Ga melt, and using the applied As pressure to serve as the parameter.

Example 2

Fig. 4 shows the dependency of carrier density upon As vapor pressure.

Under a constant growth temperature of 820°C and a constant amount of Si ($3 \times 10^{-3}$ weight%) into a Ga melt, and by varying the As vapor pressure which is applied, an epitaxial growth was conducted on a highly resistive substrate. In the drawing, mark ○ indicates the $n$ type, and mark ● indicates the $p$ type in case the measurement was performed at 300°K. Mark △ indicates the $n$ type, and mark ▲ indicates the $p$ type in case the measurement was carried out at 77°K. As mentioned, there was no instance wherein a change of substitution by the amphoteric impurity such as Si was noted at lattice sites due to the applied As vapor pressure. The result shows that the growth temperature was constant, and that a crystal growth was conducted in an ideal condition. The chart shows that, in the region wherein the As vapor pressure was lower than 1 Torr, the $n$ type was exhibited, whereas in the region wherein it was in the range 1 to 55 Torr, the $p$ type was exhibited, and that in the As pressure region above 55 Torr, the $n$ type was exhibited (1 Torr = 133 Pa). More specifically, at the As pressure of 55 Torr, the carrier concentration showed to become minimum, and the fact that the conductivity type alters at such condition signifies, as will be apparent also from the result of the other research done by the present inventor, that the value of this vapor pressure corresponds to such As pressure at which the deviation of the crystal from the stoichiometric composition becomes minimum. In the region wherein the As vapor pressure is lower than the region mentioned just above, As vacancies are easily introduced, causing the lattice sites of As to be substituted by Si, so that the $p$ type is exhibited. Above 55 Torr, the Si substitutes the Ga lattice sites and shows the $n$ type, and this can be explained without contradiction even when compared with the result of other experiments. It is, however, not possible to explain, at present, that the carrier concentration becomes minimum in the vicinity of 1 Torr in Fig. 4.

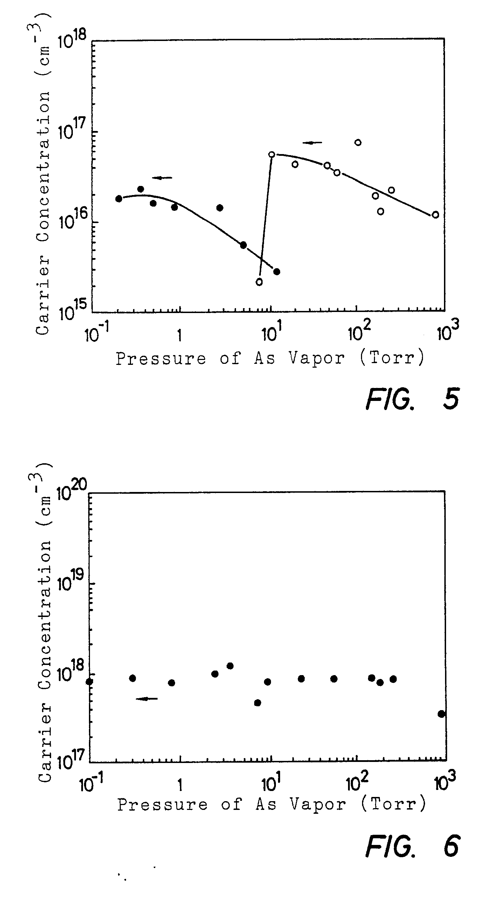

Fig. 5 shows the result of measurement done of the crystal obtained by increasing the weight% content of Si in the Ga melt to $9.1 \times 10^{-3}$ weight%, with the other conditions being the same as those of Fig. 4. It will be noted that the As pressure for the conversion from the $p$ type to the $n$ type is in the vicinity of 7 Torr, and it is apparent that, with an increase in the density of Si in the Ga melt, the As vapor pressure at which the conductivity type undergoes a conversion moves toward the lower pressure side. In the drawing, mark ○ indicates the $p$ type and mark ● indicates the $p$ type.

The result of the measurement done when the ratio by weight% of Si is increased to $1.1 \times 10^{-1}$ weight% is shown in Fig. 6. In this instant case, unlike the preceding two examples, the $p$ type conductivity is exhibited throughout the entire ranges of As vapor pressures under which the growth was conducted. In these As pressure range, no conversion phenomenon to the $n$ type was observed. However, precisely speaking, as the range of these As pressures with which the experiments were conducted, they are, in fact, the pressures which block the growth of crystal owing to dissociation of melt on the lower As pressure side and it is impossible to perform a growth at an As vapor pressure lower than said lower pressure side, and, on the other hand, the higher pressure side experimented has to stand on the consideration of the limit of mechanical strength of the quartz ampule. A conversion phenomenon might be observed in an As pressure region outside this range, but in such As pressure region, there will be exhibited a pattern different from the results shown in Figs. 4 and 5.

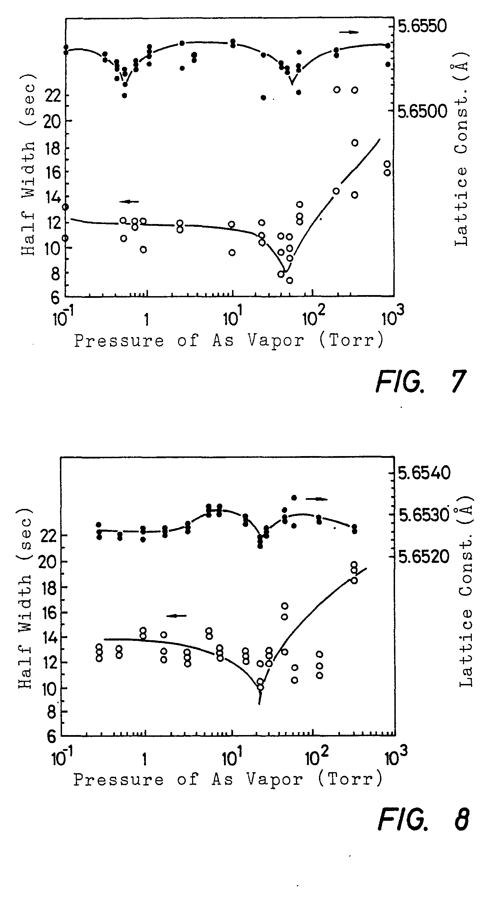

Next, for the respective doping amounts of Si, X-ray was used to examine the crystallinity of the doped grown layer, to thereby cause the respective crystals to depict their rocking curves, respectively. Figs. 7 to 9 show the instances that the lattice constant and the half width of the rocking curve which are observed from said X-ray examination are plotted against the applied As pressures.

Minimum values of lattice constant and half width are observed in each one of the densities of Si introduced into the respective batches of melt. In case of the minimum amount of Si introduced into the melt, i.e. $3 \times 10^{-3}$ weight%, shown in Fig. 7, both the lattice constant and the half width values showed the minimum at 50 Torr which is substantially equal to the As pressure which causes $p$ to $n$ type conversion shown in Fig. 4.

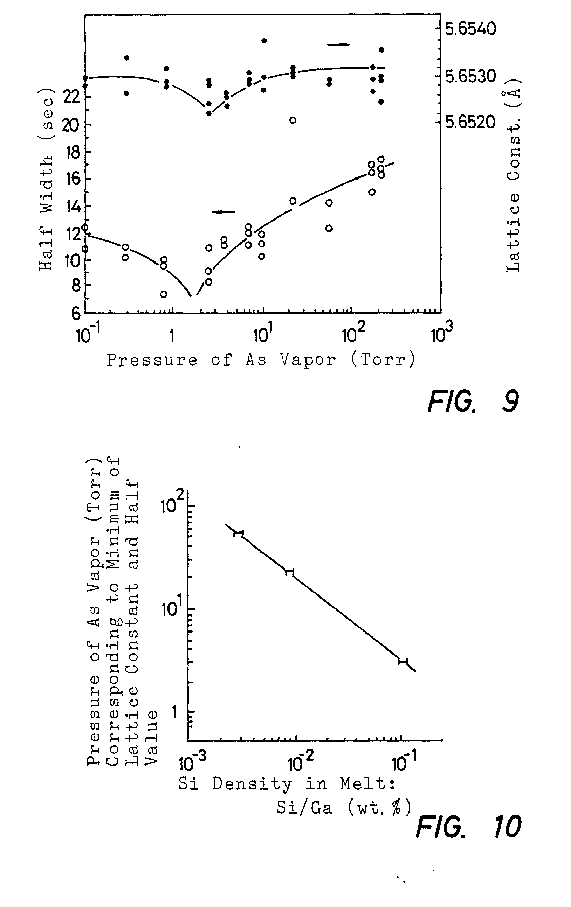

In case the amount of Si added is increased further to $9.1 \times 10^{-3}$ weight% as shown in Fig. 8, the As pressures at which minimum values were observed are in the vicinity of 20 Torr which represent values of As pressure higher than the values at which $p$ to $n$ type conversion takes place in Fig. 5. Furthermore, in case of $1.1 \times 10^{-1}$ weight% shown in Fig. 9, minimum values of lattice constant and half width were noted in the vicinity of 2 Torr of As vapor pressure.

The present inventor priorly examined the crystallographic characteristics of GaAs crystals grown by the application of an As pressure during the solution growth, and has made clear that, in case the lattice constant and the half width of the rocking-curve become minimum, the crystallinity of the grown crystal is the best. The results described above show the fact that the As vapor pressure for minimizing the deviation of the crystal from the stoichiometric composition depending on the amount of Si introduced differs from the As vapor pressure which causes a conversion of the conductivity type from the $p$ type to the $n$ type. More specifically, in case the amount of Si which is introduced is small, the As pressure at which the deviation from the stoichiometric composition of the grown crystal becomes minimum is in substantial agreement with the As pressure which causes the conductivity type converting phenomenon. However, it has become clear that, with an increase in the amount of Si which is introduced, the difference in the pressures of these two becomes greater.

The relationship between this amount of Si which is introduced, i.e. Si/Ga (weight%), and the As pressure value $P_{As\ min.}$ at which both the lattice constant and the half width of the rocking curve become minimum is shown in Fig. 10. From this, it has been found that there is the following relationship: $P_{As\ min.}\ \alpha W(Si/Ga)^{-1}$.

As has been discussed above, in the solution growth of a Group III—V compound semiconductor crystal such as GaAs crystal, the art of causing a conversion of the conductivity type of the crystal by doping, into the melt, such an amphoteric impurity as Si is one which makes use of the phenomenon which arises during the cooling process of the conventional Nelson method (slow cooling method), and in the past such growth has been performed conventionally in the circumstance wherein the crystal perfection is poor and wherein the crystal perfection cannot be controlled. In good contrast thereto, there has been adopted in the present invention the finding that, even in the solution growth for causing the growth of a crystal at a constant temperature, preferably relying on the temperature difference technique, there can be developed the phenomenon of converting the conductivity type of the grown layer, and furthermore by controlling the vapor pressure of the constituent element which is introduced to the melt and has a higher vapor pressure, both the conductivity (carrier concentration) and the conductivity type converting phenomenon, i.e. the substitution of the lattice sites by the amphoteric impurity, can be controlled under the best condition of the crystallinity. The present invention provides a method of such control.

The above-mentioned method of the present invention is not limited to the instance wherein Si is added to GaAs which is the example case described above, but needless to say a similar phenomenon may be noted when any other Group IV element is added to any other Group III—V compound semiconductor. In any case, it should be noted that the present invention has made it possible for the first time to provide the method, in performing a solution growth at a constant growth temperature, to control the deviation from the stoichiometric composition of the grown crystal layer by controlling the vapor pressure of that crystal-constituting Group V element such as As which is supplied onto the melt from thereabove and which has a higher vapor pressure over the other constituting element, thereby varying the solubility of the solute in the melt, and to thereby control the lattice sites of atomic substitution (i.e. either the site of lattice on the Ga side or that on the As side) by such Group IVa amphoteric element as Si.

**Claims**

1. A solution growth method which controls a conductivity type of a crystal layer of a Group III—V compound semiconductor to be grown from solution comprised of a solvent and a solute by an epitaxial growth process under the conditions comprising:

a) using a Group IVa element of the Periodic Table to serve as an impurity for determining the conductivity type of the crystal layer to be grown;

b) using a constant growth temperature; and

c) supplying, during the growth process, a vapor of a crystal-constituting Group V element onto a solution surface being contacted by a substrate on which said crystal layer is to be grown, while controlling the pressure of said vapor.

2. A solution growth method according to Claim 1, in which:

said epitaxial growth process is held constant and stable by adopting a temperature difference technique.

3. A solution growth method according to Claim 1, in which:

said Group IVa element is Si, and

said Group V element is As atom.

4. A solution growth method according to Claim 3, in which:

said solution contains Ga, and

said crystal layer to be grown is a GaAs crystal layer.

5. A solution growth method according to Claim 4, in which:

said crystal layer to be grown is a mixed crystal layer consisting of GaAs crystal and other Group III—V compound semiconductor crystal.

6. A solution growth method according to Claim 3 or 4, in which:

the pressure of As vapor which is applied is controlled to be at a value between 133 Pa (1 Torr) and $1.33.10^5$ Pa ($10^3$ Torr).

7. A solution growth method according to Claim 3 or 4, in which:

the pressure of As vapor which is applied is so controlled as to bring about a minimum value of a lattice constant of a grown crystal layer.

8. A solution growth method according to Claim 1, in which:

the vapor pressure of the Group V element which is applied is so controlled as to bring about a minimum value of a lattice constant of a grown crystal layer.

9. A solution growth method according to Claim 1, in which:

the vapor pressure of the Group V element is varied during the growth process to thereby vary said conductivity type in a grown crystal layer.

10. A solution growth method according to Claim 1, in which:

the vapor pressure of the Group V element is varied during the growth process to thereby form a *pn* junction in a grown crystal layer.

**Patentansprüche**

1. Verfahren zur Züchtung aus einer Lösung, das den Typ der Leitfähigkeit einer Kristallschicht aus einem Verbindungshalbleiter der Gruppen III—V gezielt beeinflußt, die aus einer ein Lösungsmittel und einen gelösten Stoff umfassenden Lösung mittels eines Vorgangs der epitaxialen Abscheidung unter Bedingungen gezüchtet werden soll, die

a) die Verwendung eines Elements der Gruppe IVa des Periodensystems, das als Verunreinigung zur Festlegung des Typs der Leitfähigkeit der zu züchtenden Kristallschicht dient,

b) die Anwendung einer konstanten Abscheidungs-temperatur und

c) die Zufuhr eines Dampfs eines kristallbildenden Elements der Gruppe V während des Abscheidungsvorgangs auf eine Oberfläche der Lösung, die sich in Berührung mit einem Substrat befindet, auf dem die Kristallschicht abgeschieden werden soll, wobei der Druck dieses Dampfes geregelt wird, umfassen.

2. Verfahren zur Züchtung aus einer Lösung nach Anspruch 1, worin der Vorgang der epitaxialen Abscheidung durch die Anwendung einer Temperaturdifferenz-Technik konstant und stabil gehalten wird.

3. Verfahren zur Züchtung aus einer Lösung nach Anspruch 1, worin das Element der Gruppe IVa Si ist und das Element der Gruppe V ein As-Atom ist.

4. Verfahren zur Züchtung aus einer Lösung nach Anspruch 3, worin die Lösung Ga enthält und die abzuscheidende Kristallschicht eine GaAs-Kristallschicht ist.

5. Verfahren zur Züchtung aus einer Lösung nach Anspruch 4, worin die abzuscheidende Kristallschicht eine aus einem GaAs-Kristall und einem Kristall eines anderen Verbindungshalbleiters der Gruppen III—V bestehende Mischkristallschicht ist.

6. Verfahren zur Zuchtung aus einer Lösung nach Anspruch 3 oder 4, worin der Druck des As-Dampfs, der eingesetzt wird, so geregelt wird, daß er einen Wert zwischen 133 Pa (1 Torr) und $1,33 \cdot 10^5$ Pa ($10^3$ Torr) hat.

7. Verfahren zur Züchtung aus einer Lösung nach Anspruch 3 oder 4, worin der Druck des As-Dampfs, der eingesetzt wird, so geregelt wird, daß er einen Minimalwert der Gitterkonstante der abgeschiedenen Kristallschicht liefert.

8. Verfahren zur Züchtung aus einer Lösung nach Anspruch 1, worin der Dampfdruck des Elements der Gruppe V, das eingesetzt wird, so geregelt wird, daß er einen Minimalwert der Gitterkonstante der abgeschiedenen Kristallschicht liefert.

9. Verfahren zur Züchtung aus einer Lösung nach Anspruch 1, worin der Dampfdruck des Elements der Gruppe V während des Abscheidungsvorgangs variiert wird, um dadurch den Typ der Leitfähigkeit in der abgeschiedenen Kristallschicht zu variieren.

10. Verfahren zur Züchtung aus einer Lösung nach Anspruch 1, worin der Dampfdruck des Elements der Gruppe V während des Abscheidungsvorgangs variiert wird, um dadurch einen pn-Übergang in der abgeschiedenen Kristallschicht zu bilden.

**Revendications**

1. Un procédé de croissance en solution qui régit le type de conductivité d'une couche cristalline d'un semi-conducteur de composé des Groupes III—V à faire croître par un processus de croissance épitaxiale à partir d'une solution constituée d'un solvant et d'un soluté, dans les conditions qui consistent à:

a) utiliser un élément du Groupe IVa du Tableau Périodique comme impureté servant à déterminer le type de conductivité de la couche cristalline à faire croître;

b) utiliser une température de croissance constante; et

c) envoyer, pendant le processus de croissance, la vapeur d'un élément du Groupe V constitutif du cristal sur une surface de la solution qui est mise en contact avec un substrat sur lequel doit croître ladite couche cristalline, tout en réglant la pression de ladite vapeur.

2. Un procédé de croissance en solution selon la revendication 1, dans lequel:

ledit processus de croissance épitaxiale est maintenu constant et stable en adoptant une technique à différence de températures.

3. Un procédé de croissance en solution selon la revendication 1, dans lequel:

ledit élément du groupe IVa est Si, et

ledit élément du Groupe V est As atomique.

4. Un procédé de croissance en solution selon la revendication 3, dans lequel:

ladite solution contient Ga, et

ladite couche cristalline à faire croître est une couche cristalline de GaAs.

5. Un procédé de croissance en solution selon la revendication 4, dans lequel:

ladite couche cristalline à faire croître est une couche cristalline mixte constituée d'un cristal de GaAs et d'un autre cristal de semi-conducteur de composé des Groupes III—V.

6. Un procédé de croissance en solution selon la revendication 3 ou 4, dans lequel:

la pression de la vapeur de As qui est appliquée est réglée à une valeur comprise entre 133 Pa (1 torr) et $1,33.10^5$ Pa ($10^3$ torrs).

7. Un procédé de croissance en solution selon la revendication 3 ou 4, dans lequel:

la pression de la vapeur de As qui est appliquée est réglée de façon à donner une valeur minimale à une constante de réseau d'une couche cristalline obtenue par croissance.

8. Un procédé de croissance en solution selon la revendication 1, dans lequel:

la pression de vapeur de l'élément du Groupe V qui est appliquée est réglée de façon à donner une valeur minimale à une constante de réseau d'une couche cristalline obtenue par croissance.

9. Un procédé de croissance en solution selon la revendication 1, dans lequel:

la pression de vapeur de l'élément du Groupe V est modifiée pendant le processus de croissance pour faire ainsi varier ledit type de conductivité dans une couche cristalline obtenue par croissance.

10. Un procédé de croissance en solution selon la revendication 1, dans lequel:

la pression de vapeur de l'élément du Groupe V est modifiée pendant le processus de croissance pour former ainsi une jonction *p-n* dans une couche cristalline obtenue par croissance.

FIG. 1

FIG. 2

FIG. 3

FIG. 4

**FIG. 5**

**FIG. 6**

0 090 521

FIG. 7

FIG. 8

4

FIG. 9

FIG. 10

5